# EUROPEAN PATENT APPLICATION

(11) **EP 2 287 903 A2**
(43) Date of publication of application: **23.02.2011**
(21) Application number: 10171813.8
(22) Date of filing: 03.08.2010
(51) Int. Cl.: H01L 23/04, H01L 23/495

(54) **Suspended lead frame electronic package**

(30) Priority: 18.08.2009 US 543290
(71) Applicant: Honeywell International Inc., Morristown, NJ 07962 (US)
(72) Inventor: Eeskridge, Mark, Morristown, NJ 07962-2245 (US)
(74) Representative: Buckley, Guy Julian

(57) **Abstract**

An apparatus and method for packaging an electronic device (12) that mechanically isolates the electronic device from its supporting substrate (38), eliminating transfer of mechanical stress from the substrate to the device. The apparatus includes a plurality of elongated members (26) that extend from a frame (14) support to a center opening, where the ends of the elongated members together support the electronic device. The shape, material and orientation of the elongated members combine to both support the electronic device and absorb mechanical force transmitted from the substrate to the support frame. In one example, the absorbing portion is substantially perpendicular to the direction of the transmitted force and the transmitted force is absorbed by mechanical displacement of one end of the perpendicular portion. The apparatus and method are particularly effective in eliminating the negative effects of thermal expansion mismatch between the electronic device and its supporting substrate.

## Description

### BACKGROUND OF THE INVENTION

The materials from which semiconducting devices are made often have a coefficient of thermal expansion (CTE) significantly different from the CTE of their substrate material. For the case of a device bonded directly to a substrate, if the thermal expansion mismatch is ignored, stress can be imparted to the semiconductor device from the substrate. Sufficient stress can lead to broken electrical connections or damage to the semiconductor device. Through engineering, the CTE of substrate materials are often shifted to more closely match that of the semiconductor device. However achieving the CTE match can require engineering trade-offs.

In a separate function, lead frames are used to support the semiconductor device during assembly and provide electrical connections to the inputs and outputs of the semiconductor device after assembly. The lead frame includes a die paddle, which supports the semiconductor device during assembly and leads that serve as the electrical connections. The semiconductor device is connected to the leads by either wire bonding or tape automated bonding.

### SUMMARY OF THE INVENTION

The present invention provides an apparatus and method for packaging an electronic device that mechanically isolates the device from its supporting substrate, eliminating transfer of mechanical stress from the substrate to the device. The apparatus includes a plurality of elongated members that extend from a frame support to a center opening, where the ends of the elongated members together support the electronic device. The shape, material and orientation of the elongated members combine to both support the electronic device and absorb mechanical force transmitted from the substrate to the support frame. In one example, the absorbing portion is substantially perpendicular to the direction of the transmitted force and the transmitted force is absorbed by mechanical displacement of one end of the perpendicular portion. The apparatus and method are particularly effective in eliminating the negative effects of thermal expansion mismatch between the electronic device and its supporting substrate.

### BRIEF DESCRIPTION OF THE DRAWINGS

Preferred and alternative embodiments of the present invention are described in detail below with reference to the following drawings:

FIGURE 1 shows a perspective view of an electronic semiconductor package assembly formed in accordance with the invention under assembly;

FIGURE 2 shows a top x-ray view of the electronic semiconductor package assembly of FIGURE 1;

FIGURE 3 shows a cross-sectional view of the completed electronic semiconductor package assembly in accordance with the present invention.

### DETAILED DESCRIPTION OF THE INVENTION

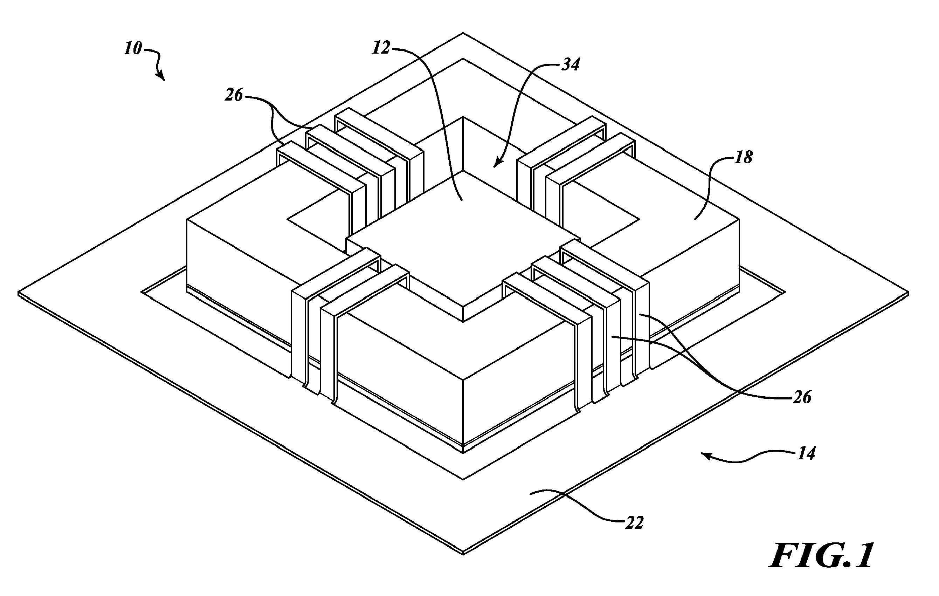

FIGURE 1 shows a perspective view of a semiconductor electronic package assembly 10 under assembly, including an electronic semiconductor device (die) 12, a lead frame 14, and a lead frame support 18. The lead frame 14 includes a perimeter support 22 and a plurality of support fingers 26. The lead frame support 18 surrounds a center opening 34.

The die 12 is a Micro Electro-Mechanical Systems (MEMS) sensor, but can also be any kind of semiconductor device. In this embodiment, the die 10 is a square MEMS sensor with a wide, flat aspect ratio.

The support fingers 26 are elongated members made of metal or polymer that extend inward from the perimeter support 22 toward the center of the lead frame 14. The support fingers 26 are stiff, but not inflexible. The support fingers 26 are sufficiently stiff to resist displacement under a rapid acceleration, but are sufficiently flexible to absorb a displacement under a gradually applied force, such as caused by an applied stress from a thermal expansion mismatch.

The support fingers 26 connect to the perimeter support 22 at a top inside edge of the perimeter support 22, however alternative connection points are possible. The support fingers 26 are typically narrow in width and thickness compared with their length, however wider and thicker fingers are possible. The perimeter support 22 is a thin, flat frame. The perimeter support 22 is thin compared with its width, but other aspect ratios are possible.

The lead frame support 18 is a ring or frame. The lead frame support 18 can have a wide range of widths and thicknesses. The center opening 34 can also be a range of sizes, but the dimensions of the center opening 34 are typically greater than the width and thickness of the lead frame support 18.

In this embodiment, the die 12, the lead frame support 18, and the perimeter support 22 each lie one inside the next within a substantially horizontal plane: the die 12 inside the lead frame support 18, and the lead frame support 18 inside the perimeter support 22. The support fingers 26 of the lead frame 14 extend over the top face of the lead frame support 18, and under the lower face of the die 12. By the fact that the support fingers 26 pass over the lead frame support 18, the lead frame support 18 carries the lead frame 14. By the fact that the support fingers 26 of the lead frame 14 pass under the die 12, the lead frame carries the die.

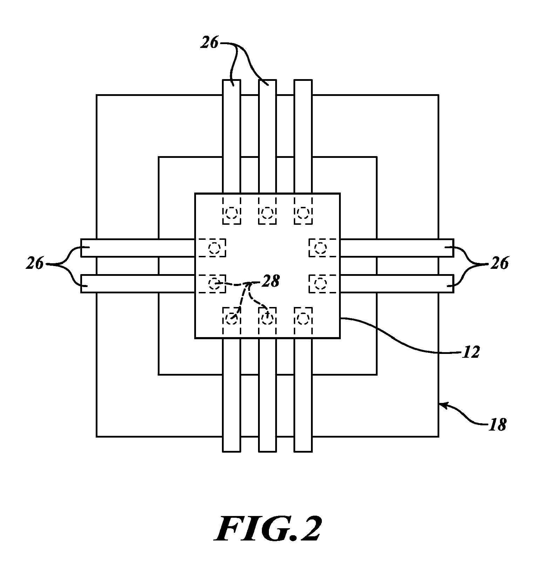

FIGURE 2 shows in an x-ray top view, through the die 12, the position of the support fingers 26 underneath the die. The support fingers 26 contact the underside of the die 12, possibly at bond pads 28 on the bottom face of the die. At least end portions of the support fingers 26 may be coated with an aluminum thin film deposition or an electrolytic gold deposition to facilitate attachment of bond pads 28 on the die 12 to the support fingers 26 by a solder, tape automated bonding (TAB), or conductive epoxy operation. In the view of FIGURE 2 the perimeter support 22 has been separated and removed from lead frame 14.

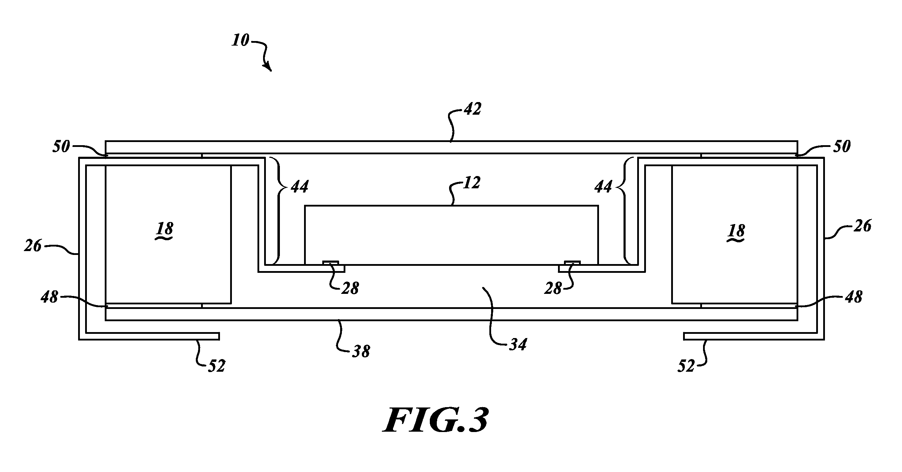

FIGURE 3 shows a cross-sectional view of the semiconductor electronic package assembly 10 after assembly, including the die 12, the lead frame support 18, the lead frame support fingers 26, a substrate 38, a lid 42 and a first and second sealing joints 48, 50. The lead frame perimeter support 22 is absent due to its removal during a final assembly step. In this embodiment, the support fingers 26 are longer than in the previous embodiment, and extend under the lead frame support 18.

The substrate 38 is joined to the bottom face of the lead frame support 18 by the first sealing joint 48. The substrate 38 provides a structure to support all the other elements of the semiconductor electronic package assembly 10. The lid 42 is joined to the top face of the lead frame support 22 by the second sealing joint 50. The lid 42 closes the die 12 off from the outside atmosphere. The lid 42 is optional, depending on if the die 12 needs to be hermetically sealed, sealed only against moisture, or not sealed at all. The first and second sealing joints 48, 50 use industry standard bonding techniques, for example solder, epoxy, adhesive, or glass frit.

In this embodiment, the plurality of support fingers 26 extends beneath the lead frame support 18 to form a plurality of horizontal pads 52. The horizontal pads 52 are a point where the plurality of fingers 26 could be attached to an outside electrical interface, if the support fingers 26 are also being used as electrical connections. In this embodiment, the support fingers 26 first extend from below the substrate 38 and upward along the outer face of the lead frame support 18. Then they extend over the top face of the lead frame support 18 and underneath the die 12, as described in the previous embodiment.

The cross-sectional view shows a vertical segment 44 of the support fingers 26 that provides flexibility for the support fingers 26 to absorb displacement in the substrate 38 due to an applied shear stress, such as thermal expansion. For example, in a cooling environment (such as following a solder re-flow step during fabrication), due to CTE mismatch the substrate 38 may contract significantly more than the die 12. If the die 12 is bonded directly to the substrate 38, compressive stress from the contracting substrate 38 would be imparted into the less contracting die 12. In accordance with this invention, compressive stress from the contracting substrate 38 is imparted to the lead frame support 18 to which it is bonded. But these stresses are not transferred to the die 12 due to flexibility in the vertical segment 44 of the support fingers 26 that suspend the die 12. In this embodiment, the top of the vertical segment 44 may move inward due to the contracting lead frame support 18, but the bottom of the vertical segment 44 would remain substantially fixed. Other shapes and orientations of the support fingers 26 are possible that take up the stress imparted by the expanding or contracting substrate.

For purposes of automated manufacturing and ease of handling, the lead frame 14, and especially the perimeter support 22, may include holes, grooves, notches, and/or other means known to those of ordinary skill in the art. In one embodiment, the thickness of the lead frame 14 is between 0.25 and 1 mm and the width of the perimeter support 22 is between 2 and 20 mm. Any number of support fingers 26 is also possible, and there would likely be more support fingers 26 than the number shown in the embodiment of FIGURE 1, 2 or 3. The support fingers 26 may also have varying width, pitch and distribution along the perimeter support 22 of the lead frame 14. In one embodiment, the thickness of the support fingers 26 is the same as the perimeter support 22, between 0.25 and 1 mm thick, and the width of the support fingers 26 is between 0.1 and 1 mm.

The lead frame support 18 may also be curved, round, or have an irregular shape and may also have a curved, round, or irregularly-shaped cross-sectional profile. The lead frame support 18 may also be an incomplete ring. For example the lead frame support 18 may include two semi-circle sections positioned opposite one another around the die 12, or four short independent straight segments on each side of the die 12. The lead frame support 18 can be manufactured from a variety of materials, for example from ceramics for hermetic applications or polymers for low performance or cost-sensitive applications.

The segment of the support fingers 26 outside and below the lead frame support 18 may also serve as a mechanical isolator, the same way the vertical segment 44 of the support fingers 26 do. In the example embodiment of FIGURE 3, a "C" style shape is shown, although other shapes for the support fingers 26 outside and below the lead frame support 18 are also possible.

The advantage of the semiconductor electronic package assembly 10 is that the negative impact of shear stresses due CTE mismatch or other sources between the electronic semiconductor device 12 and the substrate 38 is averted without requiring re-engineering of the substrate 38. The lead frame support 18 also provides the benefit of a center opening 34 that provides a convenient support for the flat lid 42 to seal the die 12. The semiconductor electronic package assembly 10 can also be manufactured relatively simply, lending itself to automated manufacturing techniques.

The support fingers 26 and lead frame support 18 may take on many shapes, orientations and material compositions.
The embodiments of the invention in which an exclusive property or privilege is claimed are defined as follows:

## Claims

1. An electronic package assembly (40) comprising:
an electronic device (12);
a frame (14); and
a plurality of elongated members (26) extending between the electronic device and the frame;
wherein the frame supports the elongated members, wherein at least two elongated members support the electronic device at least partially within a cavity of the frame, and wherein at least one elongated member is configured to absorb a shear force transmitted from the frame.

2. The assembly of Claim 1, further comprising a substrate (38), wherein a first face of the frame is bonded to a first face of the substrate,
wherein the at least two elongated members extend from a second face of the frame to a first face of the electronic device, wherein the second face of the frame is on a side of the frame opposite the first face of the frame, and wherein the first face of the electronic device faces the first face of the substrate.

3. The assembly of Claim 1, wherein the at least one of the elongated members includes a segment oriented at an acute angle to the direction of the transmitted shear force and the at least one of the elongated members includes a segment oriented substantially perpendicular to the direction of the transmitted shear force.

4. The assembly of Claim 1, wherein at least one of the elongated members is made of metal.

5. The assembly of Claim 1, wherein at least an end portion of at least one elongated member is treated with a material to enhance electrical connectivity.

6. The assembly of Claim 5, wherein the material is at least one of aluminum thin film and electrolytic gold.

7. The assembly of Claim 1, wherein the plurality of elongated members are linked to one another by a perimeter support.

8. The assembly of Claim 1, wherein at least one of the elongated members extends beyond an exterior edge of the frame and wraps around the exterior edge of the frame toward a second face of the substrate.

9. The assembly of Claim 1, further comprising a lid (42) bonded to the second face of the frame.

10. The assembly of Claim 1, wherein the electronic device includes a micro-electromechanical system (MEMS) sensor or an accelerometer.
